# EUROPÄISCHE PATENTSCHRIFT

(11) **EP 2 467 727 B1**
(45) Veröffentlichungstag und Bekanntmachung des Hinweises auf die Patenterteilung: **11.09.2013**
(21) Anmeldenummer: 10737555.2
(22) Anmeldetag: 26.07.2010
(51) Int. Cl.: G01R 33/04

(54) **MAGNETFELDSENSOR UND VERFAHREN ZUR HERSTELLUNG EINES MAGNETFELDSENSORS**
MAGNETIC FIELD SENSOR AND METHOD FOR PRODUCING A MAGNETIC FIELD SENSOR
CAPTEUR DE CHAMP MAGNÉTIQUE ET PROCÉDÉ DE PRODUCTION D'UN CAPTEUR DE CHAMP MAGNÉTIQUE

(30) Priorität: 21.08.2009 DE 102009028815
(43) Veröffentlichungstag der Anmeldung: 27.06.2012
(73) Patentinhaber: Robert Bosch GmbH, 70442 Stuttgart (DE)
(72) Erfinder: SCHATZ, Frank, 70806 Kornwestheim (DE); FUCHS, Tino, 72076 Tübingen (DE); FEYH, Ando, 71732 Tamm (DE)
(86) Internationale Anmeldenummer: PCT/EP2010/060780
(87) Internationale Veröffentlichungsnummer: WO 2011/020678

(56) Entgegenhaltungen:
- US-A- 5 831 431
- CHOI S O ET AL: "An integrated micro fluxgate magnetic sensor" SENSORS AND ACTUATORS A, ELSEVIER SEQUOIA S.A., LAUSANNE, CH LNKD- DOI:10.1016/S0924-4247(97)80066-0, Bd. 55, Nr. 2, 31. Juli 1996 (1996-07-31), Seiten 121-126, XP004049672 ISSN: 0924-4247
- WON-YOUL CHOI ET AL: "Two-axis micro fluxgate sensor on single chip" MICROSYSTEM TECHNOLOGIES ; MICRO AND NANOSYSTEMS INFORMATION STORAGE AND PROCESSING SYSTEMS, SPRINGER, BERLIN, DE LNKD- DOI:10.1007/S00542-005-0060-4, Bd. 12, Nr. 4, 1. März 2006 (2006-03-01), Seiten 352-356, XP019349542 ISSN: 1432-1858
- CHIESI L ET AL: "CMOS planar 2D micro-fluxgate sensor" SENSORS AND ACTUATORS A, ELSEVIER SEQUOIA S.A., LAUSANNE, CH LNKD- DOI:10.1016/S0924-4247(99)00360-X, Bd. 82, Nr. 1-3, 1. Mai 2000 (2000-05-01), Seiten 174-180, XP004198258 ISSN: 0924-4247

## Beschreibung

### Stand der Technik

Die Erfindung geht aus von einem Magnetfeldsensor nach dem Oberbegriff des Anspruchs 1.

Solche mikromechanischen Magnetfeldsensoren sind allgemein bekannt. Beispielsweise sind aus den Druckschriften DE 44 42 441 A1 und EP 1 052 519 B1 Magnetfeldsensoren vom sogenannten "Fluxgate"-Typ bekannt, welche ein Halbleitersubstrat, ein Anregungselement, zwei Erfassungsspulen und einen magnetischen Kern umfassen. Das Anregungselement umfasst dabei jeweils eine Anregungsspule, welche mit einem eine Erregungsfrequenz aufweisenden Wechselstrom betrieben wird, wodurch im Magnetkern ein magnetischer Fluss gemäß der magnetischen Hysterese (B-H-Kurve) der gleichen Frequenz erzeugt wird. Der Magnetkern umfasst ein ferromagnetisches Material, welcher durch das Anregungselement periodisch in magnetische Sättigung gebracht wird. Magnetische Sättigung bedeutet hierbei, dass ein zusätzliches äußeres Feld keine wesentliche Erhöhung des magnetischen Flusses im Magnetkern erzeugt. Der magnetische Fluss im Magnetkern ist proportional zum Produkt aus magnetischer Permeabilität und Magnetfeld. Die Permeabilität ist im Sättigungsbereich demzufolge vergleichsweise klein, während sie beim Nulldurchgang der magnetischen Hysterese vergleichsweise groß ist. Aufgrund der Nichtlinearität der Permeabilität verursacht ein vorhandenes zu vermessendes äußeres magnetisches Feld eine Verzerrung des magnetischen Flusses, welches mittels der Erfassungsspulen detektierbar ist. Die Erfassungsspulen sind dazu gegenläufig um den Magnetkern herum angeordnet, so dass die Summe der in den Erfassungsspulen durch den magnetischen Fluss im Magnetkern induzierten Induktionsströme bei Abwesenheit eines zu messenden äußeren Magnetfeldes gleich null ist. Beim Vorliegen eines zu messenden äußeren Magnetfelds enthält jeder der Induktionsströme aufgrund der nichtlinearen Permeabilität des ferromagnetischen Magnetkerns unterschiedliche Harmonische der Erregungsfrequenz, welche von dem äußeren Magnetfeld abhängen. Die Summe der Induktionsströme ist daher ungleich null und ein Maß für die Größe des zu messenden äußeren Magnetfelds. Gemäß dem Stand der Technik umfasst die Anregungsspule einen Spulenquerschnitt, welcher senkrecht zu einer Haupterstreckungsebene eines Substrats der Anordnung ausgerichtet ist, wobei der Spulenquerschnitt von dem Magnetfeld mittig durchsetzt ist. Nachteilig an dieser Anordnung ist, dass die flussleitende Struktur nicht in einem Standard-CMOS-Prozess in die Anordnung implementierbar ist. Aufgrund der im CMOS-Prozess unüblichen Materialien Nickel und Eisen besteht die erhöhte Gefahr von Kontamination, so dass dieser Schritt in vielen CMOS-Linien nicht anwendbar. Gemäß dem Stand der Technik ist darüberhinaus eine Anregungsspule mit einem zur Haupterstreckungsebene parallelen Spulenquerschnitt bekannt. Aufgrund der planaren Bauweise dieser Anregungsspule ist die Realisierung eines derartigen Magnetfeldsensors vergleichsweise platz- und somit kostenaufwendig.

Die Druckschrift US 5,831,431 A offenbart einen Magnetfeldsensor mit einem Substrat und einem Magnetkern, wobei das Substrat eine Anregungsspule zur Erzeugung eines magnetischen Flusses im Magnetkern aufweist und wobei die Anregungsspule einen Spulenquerschnitt aufweist, welcher im Wesentlichen senkrecht zu der Haupterstreckungsebene des Substrats ausgerichtet ist. Die Druckschrift von WON_YOUL CHOI ET AL: "Two-axis micro fluxgate sensor on single chip "MICROSYSTEM TECHNOLOGIES; MICRO AND NANOSYSTEMS INFORMATION STORAGE AND PROCESSING SYSTEMS, SPRINGER, BERLIN, DE, Bd. 12, Nr. 4, 1. März 2006, 352 - 356 offenbart einen ähnlichen Gegenstand wie die Schrift US 5,831,431 A.

Die Druckschrift von CHOI S. O. ET AL: "An integrated micro fluxgate magnetic sensor" SENSORS AND ACTUATORS A, ELSEVIER SEQUOIA S. A., LAUSANNE, CH, Bd. 55, Nr. 2, 31. Juli 1996, 121 - 126 offenbart einen Magnetfeldsensor mit einem Substrat und einem Magnetkern, wobei das Substrat eine Anregungsspule zur Erzeugung eines magnetischen Flusses im Magnetkern aufweist und wobei die Anregungsspule einen Spulenquerschnitt aufweist, wobei der Magnetkern in radialer Richtung des Spulenquerschnitts außerhalb des Spulenquerschnitts angeordnet ist. Die Druckschrift von CHIESI ET AL: "CMOS planar 2D micro-fluxgate sensor" SENSORS AND ACTUATORS A, ELSEVIER SEQUOIA S.A., LAUSANNE, CH, Bd. 82, Nr. 1- 3, 1. Mai 2000, 174 -180 offenbart einen ähnlichen Gegenstand wie die Druckschrift von CHOI et al.

### Offenbarung der Erfindung

Der erfindungsgemäße Magnetfeldsensor und das erfindungsgemäße Verfahren zur Herstellung eines Magnetfeldsensors gemäß den nebengeordneten Ansprüchen haben gegenüber dem Stand der Technik den Vorteil, dass eine vergleichsweise bauraumkompakte und somit kosteneffiziente Realisierung eines Magnetfeldsensor ermöglicht wird, wobei gleichzeitig eine Kontamination bei der Herstellung des Magnetfeldsensor durch Fremdmaterialien, insbesondere beim Einbringen des Magnetkerns, ausgeschlossen wird. Der erfindungsgemäße Magnetfeldsensor ist dadurch vorteilhafterweise in einem Standardhalbleiterherstellungsprozess, insbesondere in einem CMOS-Prozess herstellbar. Dies wird dadurch erreicht, dass die Anregungsspule einen Spulenquerschnitt aufweist, welcher im Wesentlichen senkrecht zur Haupterstreckungsebene des Substrats ausgerichtet ist, wobei der Magnetkern in radialer Richtung des Spulenquerschnitts außerhalb des Spulenquerschnitts vorzugsweise auf dem Substrat angeordnet wird. Dies hat den Vorteil, dass die Herstellung elektrischer und elektronischer Strukturen im Substrat und insbesondere die Herstellung von Anregungs- und/oder Detektionsspulen im Substrat unabhängig von der Anordnung des Magnetkerns auf dem Substrat erfolgt und somit in Standardhalbleiterherstellungsverfahren, insbesondere in einem CMOS-Prozess realisierbar ist. Das Einbringen von Fremdpartikeln in das Substrat wird dabei ausgeschlossen. Der Magnetkern wird insbesondere erst nach dem Versiegeln des Substrats auf einer Oberfläche des Substrats angeordnet. Der Begriff "Spulenquerschnitt" im Sinne der vorliegenden Erfindung umfasst insbesondere diejenige Fläche der Anregungsspule, welche senkrecht zu dem von der Anregungsspule induzierten Magnetfeld ausgerichtet ist und durch die Windungen der Anregungsspule nach Außen begrenzt wird. In vorteilhafter Weise wird trotz der Anordnung des Magnetkerns außerhalb der Anregungsspule durch die Anregungsspule ein magnetischer Fluss im Magnetkern induziert, welche für Sensoranordnung gemäß des "Fluxgate"-Sensorprinzips zur Verfügung steht. Das Substrat umfasst in jeder beliebigen Ausführungsform vorzugsweise ein Halbleitersubstrat und besonders bevorzugt ein Siliziumsubstrat.

Vorteilhafte Ausgestaltungen und Weiterbildungen der Erfindung sind den Unteransprüchen, sowie der Beschreibung unter Bezugnahme auf die Zeichnungen entnehmbar.

Gemäß einer bevorzugten Ausführungsform ist vorgesehen, dass der Magnetkern senkrecht zur Haupterstreckungsebene außerhalb des Spulenquerschnitts und vorzugsweise auf einer, insbesondere äußeren Oberfläche des Substrats angeordnet ist. In vorteilhafter Weise wird somit eine vergleichsweise einfache und kostensparende Herstellung des Magnetfeldsensors ermöglicht, indem der Magnetkern nach der Herstellung der elektrischen und elektronischen Strukturen im Substrat, insbesondere in einem Standard-CMOS-Prozess, einfach auf bzw. senkrecht zur Haupterstreckungsebene über der Anregungsspule angeordnet wird. Dies wird vorzugsweise in einem eigenständigen Herstellungsverfahren durchgeführt. Eine Oberfläche im Sinne der vorliegenden Erfindung umfasst insbesondere eine planare Fläche des Substrats und/oder eine Einbuchtung auf einer Oberfläche des Substrats, in welche der Magnetkern eingesetzt wird.

Gemäß einer bevorzugten Ausführungsform ist vorgesehen, dass das Substrat einen Schichtaufbau umfasst, wobei die Anregungsspule eine Mehrzahl von Hinleitern und eine Mehrzahl von Rückleitern umfasst, wobei die Mehrzahl von Hinleitern und die Mehrzahl von Rückleitern vorzugsweise in verschiedenen Schichten des Schichtaufbaus senkrecht zur Haupterstreckungsebene und/oder auf verschiedenen Seiten des Substrats angeordnet sind. Besonders vorteilhaft ist somit, dass die Anregungsspule in Standardhalbleiterherstellungsverfahren herstellbar ist, wobei die Hinleiter und die Rückleiter in verschiedenen Metallisierungsebenen realisiert werden, welche vorzugsweise mittels elektrischen Kontaktelementen, sogenannter "Vias", miteinander verbunden sind. Dies ermöglicht eine vergleichsweise kosteneffiziente Herstellung des Magnetfeldsensors. Die Rückleiter dienen insbesondere dazu, die einzelnen Hinleiter der Mehrzahl von Hinleitern miteinander elektrisch leitfähig zu verbinden. Besonders bevorzugt sind die Mehrzahl von Hinleitern auf der Rückseite des Substrats angeordnet. In vorteilhafter Weise ist somit der Abstand zwischen Hin- und Rückleiter vergleichsweise groß, so dass ein größeres elektrisches Feld erzielt wird.

Gemäß einer bevorzugten Ausführungsform ist vorgesehen, dass senkrecht zur Haupterstreckungsebene eine zumindest teilweise Überdeckung der Mehrzahl von Hinleitern durch den Magnetkern vorgesehen ist. In vorteilhafter Weise wird somit von der Anregungsspule und insbesondere von einem Stromfluss durch die Hinleiter ein magnetischer Fluss in dem Magnetkern induziert. Der Magnetkern wird dabei vorzugsweise wechselweise in magnetische Sättigung getrieben und steht somit für Detektion eines äußeren Magnetfeldes gemäß dem "Fluxgate"-Prinzip zur Verfügung.

Gemäß einer bevorzugten Ausführungsform ist vorgesehen, dass senkrecht zur Haupterstreckungsebene die Mehrzahl von Hinleitern im Wesentlichen zwischen dem Magnetkern und der Mehrzahl von Rückleitern angeordnet ist. In vorteilhafter Weise ist somit der Abstand zwischen dem Magnetkern und den Hinleitern deutlich geringer als der Abstand zwischen dem Magnetkern und den Rückleitern, so dass der magnetische Fluss, welcher von den Hinleitern am Ort des Magnetkerns erzeugt wird, deutlich größer ist als der magnetische Fluss, welcher von den Rückleitern im Bereich des Magnetkerns erzeugt wird. Der resultierende magnetische Gesamtfluss wird somit durch den von den Hinleitern erzeugten magnetischen Fluss bestimmt und ist ungleich null, so dass der Magnetkern durch einen Stromfluss in der Anregungsspule in magnetische Sättigung gebracht wird. Der Magnetkern umfasst vorzugsweise ein weichmagnetisches Material und insbesondere eine Eisen-Nickel-Legierung. Der Magnetkern lässt sich daher vergleichsweise einfach magnetisieren.

Gemäß einer bevorzugten Ausführungsform ist vorgesehen, dass der Magnetfeldsensor Detektionsspulen zum Auslesen eines magnetischen Flusses im Magnetkern aufweist, wobei die Detektionsspulen vorzugsweise Spulenquerschnitte umfassen, welche parallel und/oder senkrecht zur Haupterstreckungsebene ausgerichtet sind. Die Detektionsspulen sind vorzugsweise gegensinnig zueinander angeordnet, so dass der von der Anregungsspule im Magnetkern induzierte magnetische Fluss zu elektrischen Detektionsströmen in den Detektionsspulen führt, welche sich bei Abwesenheit eines zu messenden äußeren Magnetfeldes gegenseitig aufheben. Bei der Anwesenheit eines zu messenden äußeren Magnetfeldes wird die zusätzliche vektorielle Komponente dieses äußeren Magnetfeldes ein resultierendes Signal in den Detektionsspulen induzieren, welches proportional zum zu messenden äußeren Magnetfeld ist. Die Spulenquerschnitte der Detektionsspulen sind entweder parallel oder senkrecht zur Haupterstreckungsebene ausgerichtet. In vorteilhafter Weise wird somit entweder eine vergleichsweise bauraumkompakte Anordnung der Detektionsspulen mit Spulenquerschnitt senkrecht zur Haupterstreckungsebene, ähnlich wie bei den Anregungsspulen, realisiert, wobei der Magnetkern insbesondere außerhalb des Spulenquerschnitts angeordnet ist oder es wird eine vergleichsweise einfache Spulenanordnung auf der Oberfläche des Substrats realisiert, wobei die Spulenquerschnitte in diesem Fall im wesentlichen parallel zur Haupterstreckungsebene ausgerichtet sind. Die Detektionsspulen sind üblicherweise deutlich kleiner als die Anregungsspulen ausgebildet, so dass der zusätzlich benötigte Bauraum bei einem zur Haupterstreckungsebene parallelen Spulenquerschnitt vergleichsweise klein ist.

Gemäß einer bevorzugten Ausführungsform ist vorgesehen, dass senkrecht zur Haupterstreckungsebene zwischen den Hinleitern und Rückleitern Kontaktelemente und/oder dielektrische Schichten angeordnet sind. In vorteilhafter Weise werden die Hinleiter und die Rückleiter durch die Kontaktelemente elektrisch miteinander kontaktiert, wobei die Kontaktelemente, insbesondere sogenannte "Vias", umfassen, welche verschiedene Metallisierungsebenen im Halbleiterherstellungsprozess miteinander verbinden. Die dielektrischen Schichten sind vorzugsweise dazu vorgesehen, die Hinleiter von den jeweiligen Rückleitern im Spulenquerschnitt voneinander elektrisch zu isolieren. Die dielektrischen Schichten umfassen insbesondere Oxidschichten, welche standardmäßig zwischen verschiedenen Metallisierungsebenen im Halbleiterherstellungsprozess angeordnet werden. In vorteilhafter Weise ist somit eine vergleichsweise kostengünstige Herstellung der Anregungsspule in Standardhalbleiterherstellungsverfahren möglich.

Ein weiterer Gegenstand der vorliegenden Erfindung ist ein Verfahren zur Herstellung eines Magnetfeldsensors, wobei in einem ersten Herstellungsschritt das Substrat bereitgestellt wird, wobei in einem zweiten Herstellungsschritt die Anregungsspule im Substrat hergestellt wird und wobei in einem dritten Herstellungsschritt der Magnetkern in radialer Richtung des Spulenquerschnitts außerhalb des Spulenquerschnitts angeordnet wird. Im Vergleich zum Stand der Technik wird somit eine deutlich kostengünstigere Herstellung eines vergleichsweise bauraumkompakten Magnetfeldsensors ermöglicht. Dies wird dadurch erreicht, dass der erste und zweite Herstellungsschritt in Standardhalbleiterherstellungsprozessen, insbesondere in einem Standard CMOS-Prozess realisierbar sind, so dass lediglich beim dritten Herstellungsschritt ein zusätzliches Verfahren benötigt wird, in welchem lediglich der Magnetkern im Bereich der Anregungsspule auf dem Substrat angeordnet werden muss. Insbesondere wird die Anordnung des Magnetkerns während der Herstellung der Anregungsspule nicht benötigt, so dass eine Kontamination des Halbleitermaterials durch Magnetkernmaterialien verhindert wird. In vorteilhafter Weise wird trotz der Anordnung des Magnetkerns außerhalb der Anregungsspule durch die Anregungsspule ein magnetischer Fluss im Magnetkern induziert, welche für Sensoranordnung gemäß des "Fluxgate"-Sensorprinzips zur Verfügung steht.

Gemäß einer bevorzugten Ausführungsform ist vorgesehen, dass im dritten Herstellungsschritt der Magnetkern senkrecht zur Haupterstreckungsebene außerhalb des Spulenquerschnitts und vorzugsweise auf einer, insbesondere äußeren Oberfläche des Substrats angeordnet wird, so dass der dritte Herstellungsschritt vergleichsweise einfach und kostengünstig durchführbar ist.

Gemäß einer bevorzugten Ausführungsform ist vorgesehen, dass in einem ersten Teilschritt des zweiten Herstellungsschrittes die Mehrzahl von Rückleitern erzeugt wird, dass in einem zweiten Teilschritt des zweiten Herstellungsschrittes die Mehrzahl von Hinleitern erzeugt wird und/oder dass in einem dritten Teilschritt des zweiten Herstellungsschrittes eine Mehrzahl von Kontaktelementen und/oder eine Mehrzahl von dielektrischen Schichten im Substrat erzeugt werden. Der dritte Teilschritt wird dabei vorzugsweise vor, während und/oder nach dem ersten oder zweiten Teilschritt durchgeführt. Besonders bevorzugt wird der erste, zweite und/oder dritte Teilschritt mehrfach ausgeführt. In vorteilhafter Weise wird die Anregungsspule somit in einem Standardhalbleiterherstellungsprozess herstellbar, wobei verschiedene Metallisierungsschichten nacheinander auf dem Substrat abgeschieden werden. In einer unteren Metallisierungsebene wird dabei im Rahmen des ersten Teilschritts die Mehrzahl von Rückleitern erzeugt, welche jeweils voneinander elektrisch isoliert sind. In einem späteren zweiten Teilschritt wird dann eine weitere Metallisierungsebene auf dem Substrat abgeschieden, in welcher die Mehrzahl von Hinleitern erzeugt wird. Die Hinleiter sind dabei voneinander elektrisch isoliert. In vorteilhafter Weise werden die Rückleiter und die Hinleiter, welche in verschiedenen Metallisierungsebenen angeordnet sind, durch die Kontaktelemente, sogenannte Vias, miteinander elektrisch leitfähig verbunden. Im Inneren der Anregungsspule werden die Rückleiter und die entsprechenden Hinleiter durch die dielektrischen Schichten voneinander elektrisch isoliert. In einer alternativen Ausführungsform ist vorgesehen, dass während des zweiten Herstellungsschrittes auch die Detektionsspulen des Magnetfeldsensors hergestellt werden.

Ausführungsbeispiele der vorliegenden Erfindung sind in den Zeichnungen dargestellt und in der nachfolgenden Beschreibung näher erläutert.

### Kurze Beschreibung der Zeichnungen

Es zeigen
**Figur 1** eine schematische Schnittansicht eines Magnetfeldsensors gemäß einer beispielhaften Ausführungsform der vorliegenden Erfindung,
**Figur 2** eine schematische Aufsicht eines Magnetfeldsensors gemäß der beispielhaften Ausführungsform der vorliegenden Erfindung und
**Figur 3** eine schematische Seitenansicht einer Anregungsspule und eines Magnetkerns eines Magnetfeldsensors gemäß der beispielhaften Ausführungsform der vorliegenden Erfindung.

### Ausführungsformen der Erfindung

In den verschiedenen Figuren sind gleiche Teile stets mit den gleichen Bezugszeichen versehen und werden daher in der Regel auch jeweils nur einmal benannt bzw. erwähnt.

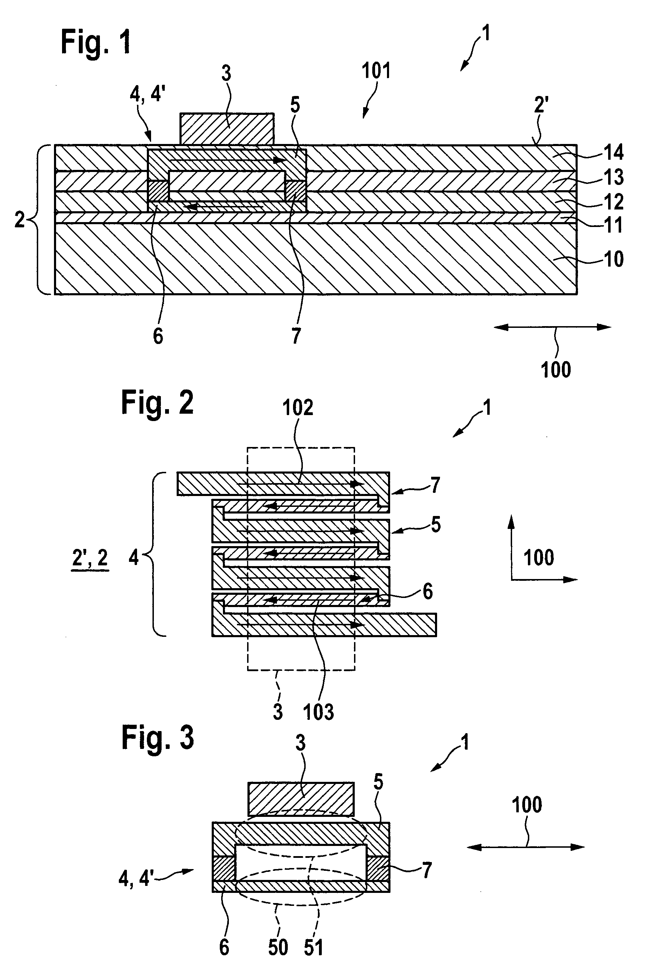

In Figur 1 ist eine schematische Schnittansicht eines Magnetfeldsensors 1 gemäß einer beispielhaften Ausführungsform der vorliegenden Erfindung dargestellt. Der Magnetfeldsensor 1 umfasst ein Substrat 2, in welchem eine Anregungsspule 4 angeordnet ist, bevorzugt ein Halbleitersubstrat und besonders bevorzugt ein Siliziumsubstrat. Die Anregungsspule 4 weist einen Spulenquerschnitt 4' auf, welcher senkrecht zu einer Haupterstreckungsebene 100 des Substrats 2 ausgerichtet ist und von den Windungen der Anregungsspule 4 begrenzt wird. Im Bereich der Anregungsspule 4 ist auf einer Oberfläche 2' des Substrats 2 ein Magnetkern 3 derart angeordnet, dass sich der Magnetkern 3 in radialer Richtung des Spulenquerschnitts 4' außerhalb des Spulenquerschnitts 4' befindet. Die Anregungsspule 4 umfasst Hinleiter 5 und Rückleiter 6, welche mittels Kontaktelementen 7 elektrisch leitfähig miteinander verbunden sind. Der Abstand zwischen den Hinleitern 5 und dem Magnetkern 3 senkrecht zur Haupterstreckungsebene 100 ist deutlich geringer, als der Abstand zwischen den Rückleitern 6 und dem Magnetkern 3 senkrecht zur Haupterstreckungsebene 100, da die Hinleiter 5 im Wesentlichen zwischen dem Magnetkern 3 und den Rückleitern 6 senkrecht zur Haupterstreckungsebene 100 angeordnet sind. Bei einem Stromfluss durch die Anregungsspule 4 wird in dem Magnetkern 3 ein magnetischer Fluss einmal durch die Hinleiter 5 und einmal durch die Rückleiter 6 erzeugt. Da der Abstand zwischen den Hinleitern 5 und dem Magnetkern 3 deutlich geringer ist, wird bei gleichem Stromfluss durch die Rück- und Hinleiter 5, 6 der von den Hinleitern 5 im Magnetkern 3 induzierte magnetische Fluss deutlich größer als der von den Rückleitern 6 im Magnetkern 3 erzeugte magnetische Fluss sein. Ein Stromfluss durch die Anregungsspule 4 erzeugt somit einen resultierenden magnetischen Fluss im Magnetkern 3, wodurch der Magnetkern 3 insbesondere in eine magnetische Sättigung getrieben wird und für Sensoranordnungen gemäß des "Fluxgate"-Sensorprinzips (auch Förster-Sonde genannt) zur Verfügung steht. Die Anregungsspule 4 ist in einen Mehrschichtaufbau im Substrat 2 aufgebaut. Das Substrat 2 umfasst dazu einen Wafer 10, auf welchem eine erste Oxidschicht 11 abgeschieden wird. Auf der ersten Oxidschicht 11 wird in einem ersten Teilschritt eines zweiten Herstellungsschritts eine erste Metallisierungsebene abgeschieden, in welcher die Mehrzahl von Rückleitern 6 hergestellt wird, wobei die Mehrzahl von Rückleitern 6 voneinander elektrisch isoliert ist. Auf dieser ersten Metallisierungsebene werden dielektrische Schichten 12, 13 und Kontaktelemente 7 innerhalb der dielektrischen Schichten 12, 13 abgeschieden. In einem zweiten Teilschritt des zweiten Herstellungsschrittes wird eine zweite Metallisierungsebene abgeschieden, in welcher die Mehrzahl von Hinleitern 5 erzeugt wird. Die Hinleiter 5 der Mehrzahl von Hinleitern 5 sind wiederum elektrisch voneinander isoliert. Auf der zweiten Metallisierungsebene wird eine weitere dielektrische Schicht 14 abgeschieden. Die dielektrischen Schichten 12, 13 und die weitere dielektrische Schicht 14 umfassen bevorzugt ein Oxid und besonders bevorzugt Siliziumdioxid. Die Mehrzahl von Rückleitern 6 und die Mehrzahl von Hinleitern 5 umfassen vorzugsweise Metall. Die Rückleiter 6 und die Hinleiter 5 sind mittels der Kontaktelemente 7, sogenannte "Vias" elektrisch leitfähig miteinander verbunden, so dass im Substrat 2 eine Anregungsspule 4 realisiert wird, welche sich parallel zur Haupterstreckungsebene 100 im Substrat 2 erstreckt. Bevorzugt ist vorgesehen, dass der Magnetfeldsensor 1 Detektionsspulen umfasst, welche in Figur 1 nicht dargestellt sind und zur Detektion eines im Magnetkern 3 durch ein zu messendes äußeres Feld, beispielsweise ein Erdmagnetfeld oder ein von einem Prüfkörper ausgehendes Magnetfeld, vorgesehen sind. Diese Detektionsspulen umfassen vorzugsweise Spulenquerschnitte, welche entweder parallel oder senkrecht zur Haupterstreckungsebene 100 ausgerichtet sind. Der Magnetfeldsensor 1 ist im Vergleich zum Stand der Technik insbesondere in einem Standardhalbleiterherstellungsverfahren und insbesondere in einem CMOS-Prozess herstellbar.

In Figur 2 ist eine schematische Aufsicht eines Magnetfeldsensors 1 gemäß der ersten Ausführungsform der vorliegenden Erfindung dargestellt, wobei in Figur 2 eine Aufsicht des in Figur 1 dargestellten Magnetfeldsensors 1 entlang des Pfeils 101 dargestellt ist. Aus Gründen der Übersichtlichkeit zeigt die Figur 2 dabei lediglich die Mehrzahl von Hinleitern 5, die Mehrzahl von Rückleitern 6, die Kontaktelemente 7 und den Magnetkern 3. Die Hinleiter 5 sind im Wesentlichen parallel zueinander ausgerichtet und voneinander beabstandet. In der Ebene der Hinleiter 5 sind die verschiedenen Hinleiter 5 jeweils voneinander elektrisch isoliert, während in der Ebene der Rückleiter 6 die einzelnen Rückleiter 6 voneinander elektrisch isoliert sind. Die Hinleiter 5 sind mit entsprechenden Rückleitern 6 jeweils über die Kontaktelemente 7 elektrisch verbunden. Dabei ist jeweils ein Ende eines Hinleiters 5 mit einem Rückleiter 6 verbunden, während ein anderes Ende des Hinleiters 5 mit einem anderen Rückleiter 6 verbunden ist. Der Magnetkern 3, welcher die Hinleiter 5 und die Rückleiter 6 zumindest teilweise senkrecht zur Haupterstreckungsebene 100 überdeckt, ist als gestrichelte Linie schematisch dargestellt. Die Pfeile 102 repräsentieren den von den Hinleitern 5 erzeugten magentischen Fluss, welcher größer als der durch die Pfeile 103 repräsentierte magentische Fluss ausgehend von den Rückleitern 6 ist. Dies wird durch die unterschiedliche Pfeilgröße 102, 103 verdeutlicht. Die im Magnetkern 3 erzeugte Flussdichte wird somit hauptsächlich durch die Hinleiter 5 induziert, während die Rückleiter 6 hauptsächlich zur Spulenverdrahtung der Anregungsspule 4 dienen.

In Figur 3 ist eine schematische Seitenansicht eines Rückleiters 6, eines Hinleiters 5, eines Kontaktelementes 7 und eines Magnetkerns 3 eines Magnetfeldsensors 1 gemäß der ersten Ausführungsform der vorliegenden Erfindung dargestellt. Die Figur 3 zeigt darüber hinaus eine Flussdichte 50, welche durch einen Stromfluss in den Rückleitern 6 erzeugt wird und eine magnetische Flussdichte 51, welcher durch einen elektrischen Stromfluss durch die Hinleiter 5 erzeugt wird. Die magnetische Flussdichte hängt vergleichsweise stark vom Abstand zum stromführenden Leiter ab. Die vom Hinleiter 5 im Magnetkern 3 erzeugte magnetische Flussdichte ist somit deutlich größer als die vom Rückleiter 6 im Magnetkern 3 erzeugte magnetische Flussdichte, so dass sich die magnetischen Flussdichten des Rückleiters 6 und des Hinleiters 5 nicht gegenseitig kompensieren, und somit eine Nettoflussdichte im Magnetkern 3 erzeugt wird, welche für die Sensorfunktion gemäß des "Fluxgate"-Sensorprinzip des Magnetometers 1 zur Verfügung steht.

## Patentansprüche

1. Magnetfeldsensor (1) mit einem Substrat (2) und einem Magnetkern (3), wobei das Substrat (2) eine Anregungsspule (4) zur Erzeugung eines magnetischen Flusses im Magnetkern (3) aufweist und wobei die Anregungsspule (4) einen Spulenquerschnitt (4') aufweist, welcher im Wesentlichen senkrecht zu einer Haupterstreckungsebene (100) des Substrats (2) ausgerichtet ist, **dadurch gekennzeichnet, dass** der Magnetkern (3) in radialer Richtung des Spulenquerschnitts (4') außerhalb des Spulenquerschnitts (4') angeordnet ist.

2. Magnetfeldsensor (1) nach Anspruch 1, **dadurch gekennzeichnet, dass** der Magnetkern (3) senkrecht zur Haupterstreckungsebene (100) außerhalb des Spulenquerschnitts (4') und vorzugsweise auf einer, insbesondere äußeren Oberfläche (2') des Substrats (2) angeordnet ist.

3. Magnetfeldsensor (1) nach einem der vorhergehenden Ansprüche, **dadurch gekennzeichnet, dass** das Substrat (2) einen Schichtaufbau umfasst, wobei die Anregungsspule (4) eine Mehrzahl von Hinleitern (5) und eine Mehrzahl von Rückleitern (6) umfasst, wobei die Mehrzahl von Hinleitern (5) und die Mehrzahl von Rückleitern (6) vorzugsweise in verschiedenen Schichten des Schichtaufbaus senkrecht zur Haupterstreckungsebene (100) und/oder auf verschiedenen Seiten des Substrats (2) angeordnet sind.

4. Magnetfeldsensor (1) nach Anspruch 3, **dadurch gekennzeichnet, dass** senkrecht zur Haupterstreckungsebene (100) eine zumindest teilweise Überdeckung der Mehrzahl von Hinleitern (5) durch den Magnetkern (3) vorgesehen ist.

5. Magnetfeldsensor (1) nach Anspruch 3 oder 4, **dadurch gekennzeichnet, dass** senkrecht zur Haupterstreckungsebene (100) die Mehrzahl von Hinleitern (5) im Wesentlichen zwischen dem Magnetkern (3) und der Mehrzahl von Rückleitern (6) angeordnet ist.

6. Magnetfeldsensor (1) nach einem der vorhergehenden Ansprüche, **dadurch gekennzeichnet, dass** das Magnetometer (1) Detektionsspulen zur Detektion eines magnetischen Flusses im Magnetkern (3) aufweist, wobei die Detektionsspulen vorzugsweise Detektionsspulenquerschnitte aufweisen, welche parallel und/oder senkrecht zur Haupterstreckungsebene (100) ausgerichtet sind.

7. Magnetfeldsensor (1) nach einem der Ansprüche 3 - 6, **dadurch gekennzeichnet, dass** senkrecht zur Haupterstreckungsebene (100) zwischen den Hinleitern (5) und Rückleitern (6) Kontaktelemente (7) und/oder dielektrische Schichten (8) angeordnet sind.

8. Verfahren zur Herstellung eines Magnetfeldsensors (1) nach Anspruch 1 oder nach dem Oberbegriff des Anspruchs 1, **dadurch gekennzeichnet, dass** in einem ersten Herstellungsschritt das Substrat (2) bereitgestellt wird, dass in einem zweiten Herstellungsschritt die Anregungsspule (4) im Substrat (2) hergestellt wird und dass in einem dritten Herstellungsschritt der Magnetkern (3) in radialer Richtung des Spulenquerschnitts (4') außerhalb des Spulenquerschnitts (4') angeordnet wird.

9. Verfahren nach Anspruch 8, **dadurch gekennzeichnet, dass** im dritten Herstellungsschritt der Magnetkern (3) senkrecht zur Haupterstreckungsebene (100) außerhalb des Spulenquerschnitts (4') und vorzugsweise auf einer, insbesondere äußeren Oberfläche des Substrats (2) angeordnet wird.

10. Verfahren nach Anspruch 9, **dadurch gekennzeichnet, dass** in einem ersten Teilschritt des zweiten Herstellungsschrittes die Mehrzahl von Rückleitern (6) erzeugt wird, dass in einem zweiten Teilschritt des zweiten Herstellungsschrittes die Mehrzahl von Hinleitern (5) erzeugt wird und/oder dass in einem dritten Teilschritt des zweiten Herstellungsschrittes eine Mehrzahl von Kontaktelementen (7) und/oder eine Mehrzahl von dielektrischen Schichten (8) im Substrat (2) erzeugt werden.

## Claims

1. Magnetic field sensor (1) having a substrate (2) and a magnet core (3), wherein the substrate (2) has an excitation coil (4) for generating a magnetic flux in the magnet core (3), wherein the excitation coil (4) has a coil cross section (4') which is oriented substantially perpendicular to a main extent plane (100) of the substrate (2), **characterized in that** the magnet core (3) is arranged outside the coil cross section (4') in the radial direction of the coil cross section (4').

2. Magnetic field sensor (1) according to Claim 1, **characterized in that** the magnet core (3) is arranged outside the coil cross section (4') perpendicular to the main extent plane (100), and preferably on an, in particular outer, surface (2') of the substrate (2).

3. Magnetic field sensor (1) according to either of the preceding claims, **characterized in that** the substrate (2) comprises a layer structure, wherein the excitation coil (4) comprises a plurality of feed conductors (5) and a plurality of return conductors (6), wherein the plurality of feed conductors (5) and the plurality of return conductors (6) are arranged, preferably in different layers of the layer structure, perpendicular to the main extents plane (100) and/or on different sides of the substrate (2).

4. Magnetic field sensor (1) according to Claim 3, **characterized in that** the magnet core (3) at least partially covers the plurality of feed conductors (5) perpendicular to the main extent plane (100).

5. Magnetic field sensor (1) according to Claim 3 or 4, **characterized in that** the plurality of feed conductors (5) is arranged substantially between the magnet core (3) and the plurality of return conductors (6) perpendicular to the main extent plane (100).

6. Magnetic field sensor (1) according to one of the preceding claims, **characterized in that** the magnetometer (1) has detection coils for detecting a magnetic flux in the magnet core (3), wherein the detection coils preferably have detection coil cross sections which are oriented parallel and/or perpendicular to the main extent plane (100).

7. Magnetic field sensor (1) according to one of Claims 3-6, **characterized in that** contact elements (7) and/or dielectric layers (8) are arranged between the feed conductors (5) and return conductors (6) perpendicular to the main extent plane (100).

8. Method for producing a magnetic field sensor (1) according to Claim 1 or according to the preamble of Claim 1, **characterized in that** the substrate (2) is provided in a first production step, **in that** the excitation coil (4) in the substrate (2) is produced in a second production step, and **in that** the magnet core (3) is arranged outside the coil cross section (4') in the radial direction of the coil cross section (4') in a third production step.

9. Method according to Claim 8, **characterized in that** the magnet core (3) is arranged outside the coil cross section (4') perpendicular to the main extent plane (100) and preferably on an, in particular outer, surface of the substrate (2) in the third production step.

10. Method according to Claim 9, **characterized in that** the plurality of return conductors (6) is generated in a first substep of the second production step, **in that** the plurality of feed conductors (5) is generated in a second substep of the second production step, and/or **in that** a plurality of contact elements (7) and/or a plurality of dielectric layers (8) are generated in the substrate (2) in a third substep of the second production step.

## Revendications

1. Capteur de champ magnétique (1) comprenant un substrat (2) et un noyau magnétique (3), le substrat (2) présentant une bobine d'excitation (4) pour générer un flux magnétique dans le noyau magnétique (3) et la bobine d'excitation (4) présentant une section transversale de bobine (4') qui est orientée pour l'essentiel perpendiculairement à un plan de projection principal (100) du substrat (2), **caractérisé en ce que** le noyau magnétique (3) est disposé à l'extérieur de la section transversale de bobine (4') dans le sens radial de la section transversale de bobine (4').

2. Capteur de champ magnétique (1) selon la revendication 1, **caractérisé en ce que** le noyau magnétique (3) est disposé perpendiculairement au plan de projection principal (100) à l'extérieur de la section transversale de bobine (4') et de préférence sur une surface (2'), notamment extérieure, du substrat (2).

3. Capteur de champ magnétique (1) selon l'une des revendications précédentes, **caractérisé en ce que** le substrat (2) présente une structure stratifiée, la bobine d'excitation (4) comprenant une pluralité de conducteurs aller (5) et une pluralité de conducteurs retour (6), la pluralité de conducteurs aller (5) et la pluralité de conducteurs retour (6) étant disposés de préférence dans des couches différentes de la structure stratifiée perpendiculairement au plan de projection principal (100) et/ou sur des côtés différents du substrat (2).

4. Capteur de champ magnétique (1) selon la revendication 3, **caractérisé en ce qu'**un recouvrement au moins partiel de la pluralité de conducteurs aller (5) par le noyau magnétique (3) est prévu perpendiculairement au plan de projection principal (100).

5. Capteur de champ magnétique (1) selon la revendication 3 ou 4, **caractérisé en ce que** perpendiculairement au plan de projection principal (100), la pluralité de conducteurs aller (5) est disposée pour l'essentiel entre le noyau magnétique (3) et la pluralité de conducteurs retour (6).

6. Capteur de champ magnétique (1) selon l'une des revendications précédentes, **caractérisé en ce que** le magnétomètre (1) présente des bobines de détection pour détecter un flux magnétique dans le noyau magnétique (3), les bobines de détection présentant de préférence des sections transversales de bobine de détection qui sont orientées parallèlement et/ou perpendiculairement au plan de projection principal (100).

7. Capteur de champ magnétique (1) selon l'une des revendications 3 à 6, **caractérisé en ce que** perpendiculairement au plan de projection principal (100), des éléments de contact (7) et/ou des couches diélectriques (8) sont disposés entre les conducteurs aller (5) et les conducteurs retour (6).

8. Procédé de fabrication d'un capteur de champ magnétique (1) selon la revendication 1 ou selon le préambule de la revendication 1, **caractérisé en ce que** dans une première étape de fabrication, le substrat (2) est fourni, **en ce que** dans une deuxième étape de fabrication, la bobine d'excitation (4) est fabriquée dans le substrat (2) et **en ce que** dans une troisième étape de fabrication, le noyau magnétique (3) est disposé à l'extérieur de la section transversale de bobine (4') dans le sens radial de la section transversale de bobine (4').

9. Procédé selon la revendication 8, **caractérisé en ce que** dans la troisième étape de fabrication, le noyau magnétique (3) est disposé perpendiculairement au plan de projection principal (100) à l'extérieur de la section transversale de bobine (4') et de préférence sur une surface, notamment extérieure, du substrat (2).

10. Procédé selon la revendication 9, **caractérisé en ce que** dans une première étape partielle de la deuxième étape de fabrication, la pluralité de conducteurs retour (6) est produite, **en ce que** dans une deuxième étape partielle de la deuxième étape de fabrication, la pluralité de conducteurs aller (5) est produite et/ou **en ce que** dans une troisième étape partielle de la deuxième étape de fabrication, une pluralité d'éléments de contact (7) et/ou une pluralité de couches diélectriques (8) sont générés dans le substrat (2).
